# FASCICULE DE BREVET EUROPEEN

(11) **EP 3 351 057 B1**
(45) Date de publication et mention de la délivrance du brevet: **02.10.2019**
(21) Numéro de dépôt: 16763814.7
(22) Date de dépôt: 09.09.2016
(51) Int. Cl.: H05B 39/06, H05B 33/08, H01L 33/08

(54) **GESTION DE PUISSANCE D'UNE SOURCE LUMINEUSE LED A MICRO- OU NANO-FILS**
LEISTUNGSVERWALTUNG FÜR EINE MIKRO- ODER NANODRAHT-LED-LICHTQUELLE
POWER MANAGEMENT FOR A MICRO- OR NANO-WIRE LED LIGHT SOURCE

(30) Priorité: 14.09.2015 FR 1558530
(43) Date de publication de la demande: 25.07.2018
(73) Titulaire: Valeo Vision, 93012 Bobigny Cedex (FR)
(72) Inventeur: SEIF, Lothar, 93012 Bobigny (FR); ZOJCESKI, Zdravko, 93012 Bobigny (FR)
(74) Mandataire: Valeo Vision
(86) Numéro de dépôt international: PCT/EP2016/071375
(87) Numéro de publication internationale: WO 2017/046015

(56) Documents cités:
- EP-A1- 2 900 039
- DE-A1-102007 006 438
- US-A1- 2012 223 289

## Description

L'invention a trait au domaine de l'éclairage et de la signalisation lumineuse, notamment pour véhicule automobile.

Dans le domaine de l'éclairage et de la signalisation lumineuse pour véhicules automobiles, il devient de plus en plus courant d'utiliser des sources lumineuses à composants semi-conducteurs électroluminescents, par exemple des diodes électroluminescentes, LED. Un composant LED émet des rayons lumineux lorsqu'une tension d'une valeur au moins égale à une valeur seuil appelée tension directe est appliquée à ces bornes. La puissance dissipée et donc la température du composant dépend en général de manière linéaire du courant qui traverse le composant.

De manière connue, une ou plusieurs LEDs d'un module lumineux pour un véhicule automobile sont alimentées par le biais de moyens de pilotage de l'alimentation, qui comprennent des circuits convertisseurs. Les moyens de pilotage de l'alimentation sont configurés pour convertir un courant électrique d'une première intensité, par exemple fourni par une source de courant du véhicule automobile, telle qu'une batterie, en un courant de charge ayant une deuxième intensité, différente de la première. Le courant de charge a en général une intensité constante.

Lors de l'allumage d'un module lumineux, l'intensité du courant électrique qui passe par le composant LED passe en général de manière instantanée d'une valeur nulle à l'intensité du courant de charge fourni par les moyens de pilotage. Ceci engendre une dissipation de puissance qui suit le même profil, c'est-à-dire qui augmente de manière instantanée d'une valeur nulle à la puissance dissipée par la LED lorsqu'elle est parcourue par le courant de charge. La température de jonction de la LED varie donc également très rapidement, ce qui détériore en général la qualité de jonction, et donc la longévité du composant LED.

La publication US2012223289A1 montre une source lumineuse à bâtonnets électroluminescents submillimètriques.

L'invention a pour objectif de proposer une solution palliant le problème susmentionné. Plus particulièrement, l'invention a pour objectif de gérer la température d'un composant LED et la puissance dissipée par celui-ci lors de son allumage.

L'invention a pour objet un procédé de gestion de la puissance dissipée par une source lumineuse à semi-conducteur comprenant une pluralité de bâtonnets électroluminescents de dimensions submillimétriques faisant saillie d'un substrat et répartis en une pluralité de groupes identiques. Le procédé est remarquable en ce que, à partir d'un courant électrique d'une intensité constante fournie pour alimenter la pluralité de groupes, des moyens de gestion choisissent à chaque instant le nombre de groupes alimentés en série, afin de satisfaire une contrainte prédéterminée sur la puissance dissipée par l'ensemble des groupes.

De préférence, à chaque instant, tous les groupes peuvent être alimentés électriquement.

Les moyens de gestion peuvent de préférence être configurés pour subdiviser la totalité des groupes en un ou plusieurs ensembles de groupes alimentés en séries, ces ensembles étant le cas échéant alimentés en parallèle.

De préférence, les bâtonnets peuvent être agencés en matrice. La matrice peut de préférence être régulière, de façon à ce qu'il existe un espacement constant entre deux bâtonnets successifs d'un alignement donné, ou de façon à ce que les bâtonnets soient disposés en quinconce.

La hauteur d'un bâtonnet peut de préférence être comprise entre 1 et 10 micromètres.

La plus grande dimension de la face terminale peut préférentiellement être inférieure à 2 micromètres.

De préférence, la distance minimale qui sépare deux bâtonnets immédiatement adjacents peut être égale à 10 micromètres.

L'aire de la surface éclairante de la source lumineuse peut de préférence être d'au plus 8 mm².

La luminance obtenue par la pluralité de bâtonnets électroluminescents peut par exemple être d'au moins 60Cd/mm².

Les moyens de gestion peuvent de préférence choisir la configuration des groupes alimentés en série parmi une pluralité de configurations prédéterminées, chaque configuration correspondant à un niveau de puissance dissipé prédéterminé.

A un premier instant, tous les groupes peuvent de préférence être alimentés en parallèle, de façon à ce que la puissance dissipée par chacun des groupes soit minimale, et à un deuxième instant, suivant le premier instant, tous les groupes peuvent de préférence être alimentés en série, de façon à ce que la puissance dissipée par chacun des groupes soit maximale.

De préférence, le premier instant peut correspondre à un instant d'allumage de la source lumineuse. En variante, le premier instant peut correspondre à un instant auquel la température de la source dépasse une valeur seuil prédéterminée.

Au premier instant, les groupes peuvent de préférence être subdivisés en autant d'ensembles, branchés en parallèle, qu'il y a de groupes, chaque ensemble comportant un unique groupe.

Au deuxième instant, la totalité des groupes forme de préférence un unique ensemble.

A au moins un instant intermédiaire entre le premier et le deuxième instant, une partie des groupes peut être alimentée en série, de façon à ce que la puissance dissipée par les groupes alimentés en série soit d'une valeur intermédiaire entre lesdites valeurs minimales et maximales.

A l'instant intermédiaire, les groupes peuvent de préférence être subdivisés en une pluralité d'ensembles dont le nombre est strictement supérieur à un et strictement inférieur au nombre total de groupes.

De préférence, la contrainte est une fonction croissante variant d'une valeur minimale à une valeur maximale sur un intervalle de temps d'une durée prédéterminée. La contrainte de puissance correspond de préférence une contrainte de température de la source lumineuse.

De manière préférée, la durée prédéterminée est inférieure ou égale à 250 ms et de préférence inférieure ou égale à 100 ms. De préférence, une reconfiguration des groupes alimentés en série est réalisée par les moyens de gestion au plus toutes les 25 ms. La durée correspond de préférence au temps nécessaire à atteindre une température stable au niveau du composant semi-conducteur.

L'invention a également pour objet une source lumineuse à semi-conducteur, comprenant un substrat et une pluralité de bâtonnets électroluminescents de dimensions submillimétriques faisant saillie du substrat. La source lumineuse est remarquable en ce que les bâtonnets sont répartis en une pluralité de groupes identiques, chaque groupe étant configuré pour être alimenté en électricité de manière sélective.

La source lumineuse peut avantageusement comprendre des moyens de gestion configurés pour mettre en oeuvre le procédé selon l'invention.

De préférence, la source lumineuse peut comprendre plusieurs groupes de bâtonnets reliés à des anodes différentes. Chaque groupe peut être alimenté électriquement indépendamment de l'autre ou des autres. Les bâtonnets de chaque groupe peuvent avantageusement être tous du même type, c'est-à-dire émettant dans le même spectre. Les groupes peuvent avantageusement être identiques et représenter une tension directe commune. De préférence, chaque groupe peut donc comprendre sensiblement le même nombre de fils ou bâtonnets semi-conducteurs.

Les moyens de gestion peuvent de préférence être configurés pour organiser un branchement relatif, en série et/ou en parallèle, des groupes de la source lumineuse de sorte à que la puissance dissipée par l'ensemble des groupes soit inférieure ou égale à la contrainte prédéterminée.

De préférence, les moyens de gestion peuvent être configurés pour augmenter graduellement, à compter de l'allumage de la source lumineuse, le nombre de groupes branchés et alimentés en série.

De préférence, les moyens de gestion peuvent comprendre un circuit électronique et/ou un élément microcontrôleur.

De manière préférée, le substrat de la source lumineuse peut comprendre du silicium. Avantageusement, le substrat peut être en silicium.

Les moyens de gestion peuvent de préférence être intégrés dans le substrat.

De préférence, la source lumineuse peut comporter une pluralité de moyens d'injection de courant pouvant être branchés en parallèle aux groupes, les moyens de gestion étant configurés pour choisir le branchement des moyens d'injection de courant aux groupes de sorte à ce que les variations de puissance dissipée par l'ensemble des groupes entre chaque instant soient continues.

L'invention a également pour objet un module lumineux comprenant au moins une source lumineuse apte à émettre des rayons lumineux et un dispositif optique apte à recevoir les rayons lumineux et à produire un faisceau lumineux. Le module est remarquable en ce que la ou les sources lumineuses sont conformes à l'invention et en ce qu'il comprend des moyens de gestion configurés pour la mise en oeuvre du procédé selon l'invention.

Les mesures de l'invention sont intéressantes en ce qu'elles permettent de limiter la variation temporelle de dissipation de puissance, et donc la variation temporelle de température d'une source lumineuse à diodes électroluminescentes sous forme de nano- ou micro-fils, également désignés comme bâtonnets, alors que la variation temporelle du courant de charge qui traverse le composant est non-limitée, c'est-à-dire il s'agit d'une variation instantanée telle qu'elle est observée lors de l'allumage de la source lumineuse. Le procédé permet de reconfigurer l'interconnexion entre différents groupes de bâtonnets semi-conducteurs de manière dynamique en choisissant parmi une pluralité de configurations prédéterminées. L'utilisation d'une source à micro- ou nano-fils semi-conducteurs permet notamment d'utiliser un grand nombre de groupes, ce qui donne lieu à un grand nombre de configurations prédéterminées et à une granularité très fine du procédé de gestion et d'adaptation de la puissance dissipée par la source lumineuse. En plus, lorsque le substrat de la source est en silicium, le circuit électronique implémentant les moyens de gestion peut être directement implanté sur le substrat de la source. Il devient apparent que l'invention permet d'éviter de manière automatique des sauts intempestifs de température au niveau des jonctions semi-conductrices d'une source lumineuse à fils électroluminescents, ce qui augmente la durée de vie de tels composants et en réduit les besoins de maintenance et/ou de remplacement. Cet avantage est réalisé sans modifier les moyens de pilotage de l'alimentation de la source, qui fournissent un courant d'une intensité constante lorsque la source est allumée.

D'autres caractéristiques et avantages de la présente invention seront mieux compris à l'aide de la description et des dessins parmi lesquels :
- la figure 1 est une représentation d'une source lumineuse telle qu'elle intervient dans un mode de réalisation préférentiel de la présente invention ;
- la figure 2 montre de manière schématique les groupes de bâtonnets semi-conducteurs d'une source lumineuse selon un mode de réalisation préférentiel de l'invention ;
- la figure 3 représente l'évolution temporelle de l'intensité du courant I_{LED} fourni à une source lumineuse, d'une contrainte de puissance P et de la puissance dissipée suivant l'application du procédé selon un mode de réalisation préférentiel de l'invention ;
- les figures 4A-4E montrent de manière schématique des configurations possibles des groupes montrés par la figure 2, afin de réaliser le profil de puissance dissipée montré par la figure 3, selon un mode de réalisation préférentiel de l'invention.

Sauf indication spécifique du contraire, des caractéristiques techniques décrites en détail pour un mode de réalisation donné peuvent être combinées aux caractéristiques techniques décrites dans le contexte d'autres modes de réalisation décrits à titre exemplaire et non limitatif.

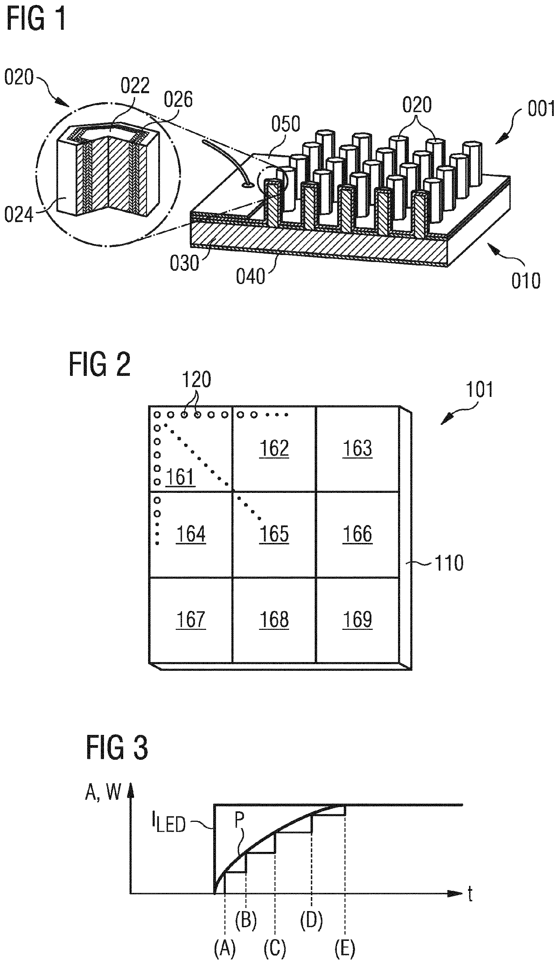

La figure 1 illustre une source lumineuse électroluminescente 001 selon un premier mode de réalisation de l'invention. La figure 1 illustre le principe de base de la source lumineuse. La source lumineuse 001 comprend un substrat 010 sur lequel sont disposées une série de diodes à électroluminescence sous forme de fils 020, également nommées bâtonnets électroluminescents, faisant saillie du substrat. Le coeur 022 de chaque diode 020 est en matériau semi-conducteur du type n c'est-à-dire dopé en électrons, alors que l'enveloppe 024 est en matériau semi-conducteur du type p c'est-à-dire dopé en trous. Une zone de recombinaison 026 est prévue entre les matériaux semi-conducteurs du type n et du type p. Il est toutefois envisageable d'inverser les matériaux semi-conducteurs en fonction notamment de la technologie choisie.

Le substrat est avantageusement en silicium et les bâtonnets ont un diamètre de moins d'un micron. En variante, le substrat comprend une couche de matériau semi-conducteur dopé en trous et les fils ont un diamètre compris entre 100 et 500 nm. Le matériau semi-conducteur dopé en électrons et en trous formant les diodes peut avantageusement être du nitrure de gallium (GaN) ou du nitrure de gallium-indium (InGaN). La hauteur d'un bâtonnet est typiquement comprise entre 1 et 10 micromètres, tandis que la plus grande dimension de la face terminale est inférieure à 2 micromètres. Selon un mode de réalisation préféré, les bâtonnets sont agencés en matrice selon une disposition régulière. La distance entre deux bâtonnets est constante et égale à au moins 10 micromètres. Les bâtonnets peuvent être disposés en quinconce. L'are de la surface éclairante d'une telle source lumineuse est d'au plus 8 mm². La source est capable de réalisé une luminance d'au moins 60 Cd/mm²

En référence à la figure 1, le substrat 010 comprend une couche principale 030, avantageusement en silicium, une première électrode ou cathode 040 disposée sur la face de la couche principale qui est opposée aux diodes 020, et une deuxième électrode ou anode 050 disposée sur la face comprenant les diodes 020. L'anode 050 est en contact avec le matériau semi-conducteur du type p formant les enveloppes 024 des diodes 020 et s'étendant sur la face correspondante du substrat 010 de manière à former une couche conductrice entre lesdites enveloppes 024 et l'anode 050. Les coeurs ou noyaux 022 des bâtonnets sont quant à eux en contact avec la couche principale semi-conductrice 030 et ainsi en contact électrique avec la cathode 040.

Lors de l'application d'une tension électrique entre l'anode et la cathode, des électrons du matériau semi-conducteur du type n se recombinent avec des trous du matériau semi-conducteur du type p et émettent des photons. La plupart des recombinaisons sont radiatives. La face émettrice des diodes ou bâtonnets est la zone p car elle est la plus radiative.

Conformément à l'invention, la source lumineuse 2 comprend plusieurs groupes de bâtonnets reliés à des anodes différentes. Chaque groupe peut ainsi être alimenté électriquement indépendamment de l'autre ou des autres. Les bâtonnets de chaque groupe sont avantageusement tous du même type, c'est-à-dire émettant dans le même spectre. Les groupes sont avantageusement identiques et représentent une tension directe commune. De préférence, chaque groupe comprend donc sensiblement le même nombre de fils ou bâtonnets semi-conducteurs.

La figure 2 montre de manière schématique une vue de face d'une source lumineuse 101 comprenant des diodes électroluminescentes en forme de fils 120 ou bâtonnets électroluminescents faisant saillie d'un substrat 110. Les bâtonnets sont répartis en une pluralité de groupes identiques 161-169. De manière exemplaire, les groupes sont montrés sous formes de carrés à dimensions identiques. D'autres dispositions et/ou géométries des groupes sont réalisables sans pour autant sortir du cadre de la présente invention. La multitude de bâtonnets 120 présents sur un composant permet notamment de prévoir une pluralité de groupes allant au-delà des neufs groupes montrés dans cet exemple.

Le procédé de gestion est décrit en référence à la source 101 de la figure 2 et à l'illustration de la figure 3. La figure 3 décrit d'une part l'évolution temporelle du courant I_{LED} fourni par une source de courant, possiblement par le biais d'éléments convertisseurs ou d'un circuit de pilotage de l'alimentation de la source 101 non-illustré. Lorsque la source 101 est allumée, la variation d'intensité du courant I_{LED} est instantanée. Afin d'éviter l'endommagement des jonctions semi-conductrices de la source 101, des moyens de gestion de la puissance dissipée sont configurés de manière à ce que la puissance dissipée par la source 101 est à tout instant inférieure à la contrainte de puissance P, tandis qu'à tout instant, tous les groupes sont alimentés électriquement. La puissance dissipée, et donc la température des jonctions semi-conductrices, augmente de manière graduelle entre une première valeur nulle et une deuxième valeur maximale selon les paliers A-E. La variation temporelle de température observée au niveau de la source 101 est donc limitée, tandis que la variation temporelle de l'intensité du courant fourni est illimitée.

Afin de réaliser l'évolution de la puissance dissipée par paliers montrée par la figure 3, les moyens de gestion sont aptes à reconfigurer de manière dynamique le branchement électrique relatif des différents groupes 161-169. Notamment, les moyens de gestion sont configurés pour adapter le nombre de groupes alimentés en série, ce qui a un impact direct sur le courant traversant les groupes correspondants, donc également sur la puissance dissipée par ceux-ci et sur leur température de jonction. En augmentant graduellement et par étapes le nombre de groupes branchés et alimentés en série, des paliers de puissance dissipée A-E sont réalisés. La durée de chaque palier correspond de préférence à au moins 25 ms, ce qui correspond généralement au temps nécessaire à l'obtention d'une température stable suite à un changement de courant dans un groupe de diodes. Les moyens de gestion peuvent notamment être implantés par un circuit impliquant des interrupteurs, transistors ou d'autres composants électroniques, ou par l'intermédiaire d'un élément microcontrôleur programmable.

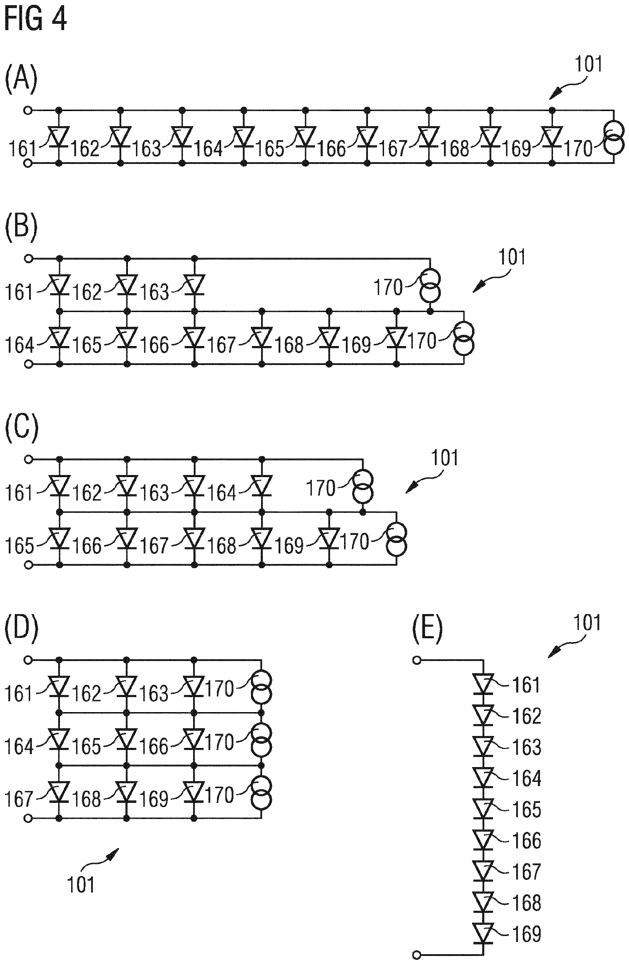

Des configurations exemplaires correspondantes aux paliers A-E montrés par la figure 3 sont données par les figures 4A à 4E respectivement. Chaque groupe de bâtonnets 161-169 est représenté par le symbole d'une seule diode électroluminescente afin de garantir la clarté du schéma. L'homme du métier saura adapter les configurations selon l'application concrète visée, selon les spécificités des groupes de sources électroluminescentes disponibles et selon le nombre de paliers à réaliser. L'adaptation de ces paramètres est à la portée de l'homme du métier sans sortir du cadre de la présente invention.

La première configuration d'alimentation exemplaire des groupes 161-169 est montrée par la figure 4A. Tous les groupes sont alimentés de manière parallèle, de manière à ce que le courant électrique qui passe par chacun des groupes soit d'une intensité minimale. La température de jonction dans chacun des groupes peut être considérée comme égale.

La configuration de la figure 4B augmente le nombre de groupes branchés en série à deux. Notamment, les paires formées par les groupes 161 et 164, 162 et 165, 163, 166 sont traversées par un courant d'une première intensité supérieure à l'intensité du courant qui les traverse dans l'exemple 4A. Leurs températures respectives sont donc sensiblement égales entre elles, mais supérieures à leurs températures respectives dans la configuration 4A. Les groupes 167-169 sont traversés par un courant d'une deuxième intensité. Dans la configuration de la figure 4C, une paire supplémentaire de groupes, 164 et 168 est branchée en série, donc la puissance dissipée, ainsi que la température globale de la source 101, augmentent par rapport aux exemples précédents.

Dans la configuration de la figure 4D, les neufs groupes 161-169 sont branchés par trois groupes de triplets en série. Chaque groupe est donc traversé par un courant d'une même intensité, supérieure à l'intensité du courant qui les a traversés dans les exemples précédents. Finalement, dans la configuration finale montrée par la figure 4E, tous les groupes de diodes 161-169 sont alimentés en série et le courant I_{LED} traverse l'intégralité des diodes. Avantageusement, des moyens d'injection de courant 170 peuvent être prévus par branchement en parallèle, ce qui permet une reconfiguration quasi continue des branchements.

En considérant une reconfiguration toutes les 25 ms, le passage de la configuration 4A jusqu'à la configuration 4E, en passant par les configurations intermédiaires, est réalisé en environ 150 ms. Cette gestion de la puissance dissipée par la source lumineuse 101 permet donc un allumage instantané de la source. Bien que le flux lumineux émis, dépendant du courant qui traverse les diodes, ne soit pas constant parmi les configurations 4A-4E, la variation rapide n'est pas perceptible à l'oeil humain. En même temps, une variation instantanée de la température de jonction des diodes est évitée, ce qui rend la source plus robuste et plus durable.

Le substrat de la source 101, duquel les fils ou bâtonnets semi-conducteurs font saillie, peut avantageusement être en silicium. Dans ce cas, les composants électroniques qui réalisent les moyens de gestion de la puissance qui viennent d'être décrits peuvent avantageusement être implantés directement dans ou sur le substrat de la source lumineuse. La source résultante gère donc de manière automatique sa puissance dissipée afin de protéger ses jonctions semi-conductrices d'une augmentation de température intempestive. De manière alternative, les moyens de gestion peuvent être réalisés sur un circuit imprimé déporté par rapport au substrat de la source lumineuse.

## Revendications

1. Procédé de gestion de la puissance dissipée par une source lumineuse (001, 101) à semi-conducteur comprenant une pluralité de bâtonnets électroluminescents de dimensions submillimétriques (020, 120) faisant saillie d'un substrat (010, 110) et répartis en une pluralité de groupes identiques (161-169), **caractérisé en ce que**, à partir d'un courant électrique d'une intensité constante I_{LED} fourni pour alimenter la pluralité de groupes, des moyens de gestion choisissent à chaque instant le nombre de groupes alimentés en série, afin de satisfaire une contrainte prédéterminée sur la puissance dissipée par l'ensemble des groupes.

2. Procédé selon la revendication 1, **caractérisé en ce que** à un premier instant, tous les groupes sont alimentés en parallèle, de façon à ce que la puissance dissipée par chacun des groupes soit minimale, et à un deuxième instant, suivant le premier instant, tous les groupes sont alimentés en série, de façon à ce que la puissance dissipée par chacun des groupes soit maximale.

3. Procédé selon la revendication 2, **caractérisé en ce que**, à au moins un instant intermédiaire entre le premier et le deuxième instant, une partie des groupes est alimentée en série, de façon à ce que la puissance dissipée par les groupes alimentés en série soit d'une valeur intermédiaire entre lesdites valeurs minimales et maximales.

4. Procédé selon une des revendications 1 à 3, **caractérisé en ce que** la contrainte est une fonction croissante variant d'une valeur minimale à une valeur maximale sur un intervalle de temps d'une durée prédéterminée.

5. Procédé selon la revendication 4, **caractérisé en ce que** la durée prédéterminée est inférieure ou égale à 250 ms.

6. Source lumineuse (001, 101) à semi-conducteur, comprenant :
- un substrat (010, 110);
- une pluralité de bâtonnets électroluminescents de dimensions submillimétriques (020, 120) faisant saillie du substrat ; **caractérisée en ce que**
les bâtonnets sont répartis en une pluralité de groupes identiques (161-169), chaque groupe étant configuré pour être alimenté en électricité de manière sélective et **en ce que** la source comprend des moyens de gestion configurés pour mettre en oeuvre le procédé selon une des revendications 1 à 5.

7. Source lumineuse selon la revendication 6, **caractérisée en ce que** les moyens de gestion comprennent un circuit électronique et/ou un élément microcontrôleur.

8. Source lumineuse selon une des revendications 6 à 7, **caractérisée en ce que** le substrat est en silicium.

9. Source lumineuse selon la revendication 8, **caractérisée en ce que** les moyens de gestion sont intégrés dans le substrat.

10. Source lumineuse selon l'une des revendications 6 à 9, **caractérisé en ce qu'**elle comporte une pluralité de moyens d'injection de courant (170) pouvant être branchés en parallèle aux groupes, les moyens de gestion étant configurés pour choisir le branchement des moyens d'injection de courant aux groupes de sorte à ce que les variations de puissance dissipée par l'ensemble des groupes entre chaque instant soient continues.

11. Module lumineux comprenant :
- au moins une source lumineuse (001, 101) apte à émettre des rayons lumineux ;
- un dispositif optique apte à recevoir les rayons lumineux et à produire un faisceau lumineux ;
**caractérisé en ce que** la ou les sources lumineuse sont conformes à une des revendications 6 à 10.

## Patentansprüche

1. Verfahren zur Steuerung der von einer Lichtquelle abgeleiteten Leistung (001 101) abgegebenen Leistung, die eine Vielzahl von Elektrolumineszenzstäbe mit Submillimeterabmessungen (020, 120) umfasst die von einem Substrat (010, 1 10) vorstehen und in eine Vielzahl identischer Gruppen (161-169) unterteilt sind, **dadurch gekennzeichnet, dass** aus einem elektrischen Strom mit einer konstanten ILED-Intensität, der zur Versorgung der Vielzahl von Gruppen zugeführt wird, Steuermittel in jedem Moment die Anzahl der in Reihe geschalteten Gruppen wählen, um eine vorbestimmte Einschränkung der von allen Gruppen abgegebenen Leistung zu erfüllen

2. Verfahren nach Anspruch 1, **dadurch gekennzeichnet, dass** zu einem ersten Zeitpunkt alle Gruppen parallel versorgt werden, so dass die von jeder der Gruppen abgeleitete Leistung minimal ist, und zu einem zweiten Zeitpunkt, nach dem ersten Zeitpunkt, werden alle Gruppen in Reihe zugeführt, so dass die von jeder der Gruppen abgeleitete Leistung maximal ist.

3. Verfahren nach Anspruch 2, **dadurch gekennzeichnet, dass** mindestens eine Zwischenzeit zwischen dem ersten und zweiten Zeitpunkt, einige der Gruppen in Reihe geschaltet werden, so dass die von den in Reihe geschalteten Gruppen abgegebene Leistung einen Zwischenwert zwischen dem Minimal- und dem Maximalwert aufweist.

4. Verfahren nach einem der Ansprüche 1 bis 3, **dadurch gekennzeichnet, dass** die Spannung eine steigende Funktion ist, die von einem Minimalwert bis zu einem Maximalwert über ein Zeitintervall einer vorbestimmten Dauer variiert.

5. Verfahren nach Anspruch 4, **dadurch gekennzeichnet, dass** die vorgegebene Zeit 30 kleiner oder gleich 250 ms ist.

6. Halbleiter-Lichtquelle (001, 101), umfassend:
- ein Substrat (010, 1 10);
- eine Vielzahl von elektrolumineszierenden Stäben mit Submillimeterabmessungen (020, 120), die aus dem Substrat herausragen; **dadurch gekennzeichnet, dass** die Stäbe in eine Vielzahl von identischen Gruppen (1 61-169) unterteilt sind, wobei jede Gruppe konfiguriert ist, um selektiv mit Strom versorgt zu werden, und dass die Quelle Verwaltungsmittel umfasst, die konfiguriert sind, um den Prozess nach einem der Ansprüche 1 bis 5 durchzuführen.

7. Lichtquelle nach Anspruch 6, **dadurch gekennzeichnet, dass** die Steuermittel eine elektronische Schaltung und/oder ein Mikrocontroller Element umfassen.

8. Lichtquelle nach einem der Ansprüche 6 bis 7, **dadurch gekennzeichnet, dass** das Substrat aus Silizium besteht.

9. Lichtquelle nach Anspruch 8, **dadurch gekennzeichnet, dass** die Steuermittel in das Substrat integriert sind.

10. Lichtquelle nach einem der Ansprüche 6 bis 9, **dadurch gekennzeichnet, dass** sie eine Vielzahl von Stromeinspeisemittel (170) umfasst, die parallel zu den Gruppen geschaltet werden können, wobei die Steuermittel konfiguriert sind, um die Verbindung der Stromeinspeisemittel zu den Gruppen so auszuwählen, dass die von allen Gruppen zwischen jedem Zeitpunkt abgegebenen Leistungsänderungen kontinuierlich sind.

11. Lichtmodul, umfassend:
- mindestens eine Lichtquelle (001, 101), die Lichtstrahlen emittieren kann;
- eine optische Vorrichtung, die in der Lage ist, die Lichtstrahlen zu empfangen und einen Lichtstrahl zu erzeugen, **dadurch gekennzeichnet, dass** die Lichtquelle(n) einem der Ansprüche 6 bis 10 entspricht.

## Claims

1. Method for managing the power dissipated by a semiconductor light source (001 101) comprising a plurality of electroluminescent rods of submillimetre dimensions (020, 120) projecting from a substrate (010, 1 10) and divided into a plurality of identical groups (161-169), **characterized in that**, from an electrical current of a constant ILED intensity supplied to supply the plurality of groups, control means at each moment choose the number of groups supplied in series, in order to satisfy a predetermined constraint on the power dissipated by all the groups.

2. A method according to claim 1, **characterized in that** for the first time all the groups are supplied in parallel, so that the power dissipated by each of the groups is minimal, and at a second time, following the first time, all the groups are supplied in series, so that the power dissipated by each of the groups is maximal.

3. A method according to claim 2, **characterized in that**, at least one intermediate time between the first and second instant, some of the groups are supplied in series, so that the power dissipated by the groups supplied in series is of an intermediate value between said minimum and maximum values.

4. A method according to one of claims 1 to 3, **characterized in that** the constraint is an increasing function varying from a minimum value to a maximum value over a range of time of a predetermined duration.

5. A method according to claim 4, **characterized in that** the predetermined time 30 is less than or equal to 250 ms.

6. A semiconductor light source (001, 101) comprising:
- a substrate (010, 1 10);
- a plurality of electroluminescent rods of submillimetre dimensions (020, 120) projecting from the substrate; **characterized in that** the rods are divided into a plurality of identical groups (1 61-169), each group being configured to be selectively supplied with electricity and **in that** the source comprises management means configured to carry out the process according to one of claims 1 to 5.

7. The light source according to claim 6, **characterized in that** the management means include an electronic circuit and/or a microcontroller element.

8. A light source according to one of claims 6 to 7, **characterized in that** the substrate is made of silicon.

9. The light source according to claim 8, **characterized in that** the control means are integrated in the substrate.

10. A light source according to one of claims 6 to 9, **characterized in that** it comprises a plurality of current injection means (170) connectable in parallel to the groups, the control means being configured to select the connection of the current injection means to the groups so that the power variations dissipated by all the groups between each instant are continuous.

11. Light module comprising:
- at least one light source (001, 101) capable of emitting light rays;
- an optical device capable of receiving the light rays and producing a light beam, **characterized in that** the light source(s) conform to one of claims 6 to 10..
